(19)

Europäisches
Patentamt

European
Patent Office

Office européen
des brevets

(11) **EP 2 713 505 B1**

(12) **EUROPEAN PATENT SPECIFICATION**

(45) Date of publication and mention
of the grant of the patent:
**12.12.2018 Bulletin 2018/50**

(21) Application number: **11768479.5**

(22) Date of filing: **30.05.2011**

(51) Int Cl.:
*H03F 1/07* *(2006.01)*      *H03F 1/02* *(2006.01)*

(86) International application number:
**PCT/CN2011/074907**

(87) International publication number:
**WO 2011/127868 (20.10.2011 Gazette 2011/42)**

(54) **DOHERTY POWER AMPLIFIER AND SIGNAL PROCESSING METHOD**

DOHERTY-LEISTUNGSVERSTÄRKER UND SIGNALVERARBEITUNGSVERFAHREN

AMPLIFICATEUR DE PUISSANCE DE DOHERTY ET PROCÉDÉ DE TRAITEMENT DU SIGNAL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**02.04.2014 Bulletin 2014/14**

(73) Proprietor: **Huawei Technologies Co., Ltd.
Longgang District
Shenzhen, Guangdong 518129 (CN)**

(72) Inventors:
 • **SU, Yongge
  Shenzhen
  Guangdong 518129 (CN)**
 • **JIAO, Liuyan
  Shenzhen
  Guangdong 518129 (CN)**
 • **WANG, Laiqing
  Shenzhen
  Guangdong 518129 (CN)**

(74) Representative: **Gill Jennings & Every LLP
The Broadgate Tower
20 Primrose Street
London EC2A 2ES (GB)**

(56) References cited:
**EP-A1- 2 159 912      CN-A- 1 349 681
CN-A- 1 501 578      CN-A- 1 943 106**

## Description

## TECHNICAL FIELD

The present invention relates to the field of communications technologies, in particular, to a Doherty power amplifier and a signal processing method.

## BACKGROUND

In a communications system, a radio frequency and microwave power amplifier is configured to amplify radio frequencies and microwave modulated signals that carry information. In order to improve spectrum utilization efficiency, modulated signals of many standards carry both phase and amplitude information, and signals of this type are non-constant envelope signals and need to be amplified by using a linear amplifier. In order to improve efficiency of a linear amplifier, distortion correction is generally performed by adopting a Doherty power amplifier (Doherty power amplifier) technology in combination with a DPD (Digital Predistortion, digital predistortion) technology.

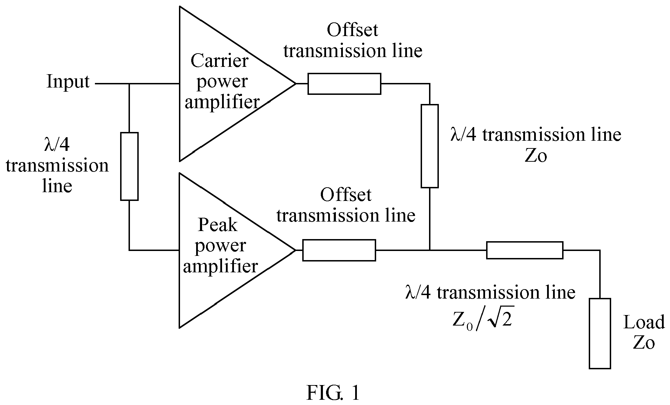

As shown in FIG. 1, a Doherty power amplifier generally includes two power amplifiers referred to as a main power amplifier (a carrier power amplifier) and an auxiliary power amplifier (a peak power amplifier), where the main power amplifier and the auxiliary power amplifier are separated from each other by using a $\lambda/4$ transmission line; a $\lambda/4$ transmission line at an input port is used to compensate for a phase offset caused by a $\lambda/4$ transmission line and output by the main power amplifier; after output of the main power amplifier and the auxiliary power amplifier is combined, impedance of the signal is converted into load impedance Zo by using another $\lambda/4$ transmission line.

The Doherty power amplifier has the feature that loads of the main and auxiliary power amplifiers of the Doherty power amplifier change with input power. When input power is low, and the auxiliary power amplifier is not enabled, a load corresponding to the main power amplifier is Za=2*Zo, saturated output power of the main power amplifier decreases by 3dB, and in the case of back-off, high efficiency is achieved; when input power is high, and both the main and auxiliary power amplifiers reach peak power, loads corresponding to the main and auxiliary power amplifiers are Za=Zp=Zo; when input power is medium, a load of the main power amplifier changes from 2*Zo to Zo, but a load Zp of the auxiliary power amplifier changes from infinity to Zo. The peak power amplifier performs active-load pulling on the main power amplifier, thereby improving efficiency of a linear amplifier.

Since the Doherty power amplifier adopts a $\lambda/4$ transmission line to perform impedance transformation, even if the power amplifier is capable of wideband operation, a conventional Doherty power amplifier architecture limits performance of the wideband operation. This is because a phase offset of a $\lambda/4$ impedance transformation network is 90° only at a center frequency, and deviation from the center frequency results in a deviation, which affects operating performance at different frequencies.

An input end of the Doherty power amplifier needs to ensure that a phase difference of 90° exists between signals distributed to the two power amplifiers, so as to compensate for a phase offset of 90° of the $\lambda/4$ impedance transformation network at an output end of the main power amplifier, thereby ensuring that the two phases are consistent at an output combination point, which may be achieved in a wideband application by adopting an existing wideband power splitter technology or using two TX (transmitter) signals with a phase difference of 90°. A function of the $\lambda/4$ impedance transformation network after two power amplifiers are combined is transforming the load impedance Zo into Zo/2, and wideband transformation may be generally implemented by adopting a multi-level transformation manner.

The $\lambda/4$ impedance transformation network at the output end of the main power amplifier is configured to, when the auxiliary power amplifier is not enabled, transform Zo/2 to 2*Zo, and is configured to, in a stage from the beginning of enabling of the auxiliary power amplifier to saturation, gradually transform impedance output by the main power amplifier from 2*Zo to Zo, and this transmission line is a key factor to wideband operation of the Doherty power amplifier. After an operating frequency deviates from the center frequency, which is equivalent to that a phase offset of a high-impedance operating state is increased or decreased, a power amplifier matching state is affected, and performance cannot be optimal in a whole band in the case of large operating bandwidth, so that a relative operating bandwidth of the Doherty power amplifier cannot be excessively great, and the performance of the Doherty power amplifier in cross-band operation may deteriorate.

A relative operating bandwidth (a ratio of an operating bandwidth to a center frequency at a position where the operating bandwidth is) of a traditional Doherty power amplifier is about 10%, and during cross-band operation, if the relative operating bandwidth is greater than 10%, a suitable power tube needs to be selected, for example, a power tube with low Cds (drain capacitance) and high impedance, so as to decrease an impedance transformation ratio, thereby reducing frequency-dependent parameters in the power tube and extending the operating bandwidth as much as possible. Alternatively, the impedance transformation network may be constructed inside the power tube, and impedance transformation is implemented by using distribution parameters such as Cds. However, it is difficult to select a power tube, and it is highly possible that a common LDMOS power tube (a laterally diffused metal oxide silicon field effect transistor) cannot meet requirements, and high-voltage LDMOS, GaN (gallium nitride), and GaAs (gallium arsenide) power tubes need to be adopted, but costs increase accordingly, and it is also difficult for commissioning.

In the prior art, a multiband Doherty architecture is provided, where two or more peak power amplifiers that separately match different frequency bands are used to pull a wideband matching main power amplifier, and a switch is used to enable a selection of an operating frequency band, so as to ensure that when a Doherty power amplifier is operating in a frequency band, an output network of another frequency band is not affected, and each frequency band may select an impedance transformation network of a different length, thereby solving the problem that the operating bandwidth of the impedance transformation network is limited. An example of such a multiband Doherty amplifier can be found in patent document EP 2 159 912. However, this method has a limitation: the Doherty power amplifier operates in only one of two or more frequency sub-bands within a period, thereby failing to meet the requirement that the Doherty power amplifier operate in multiple frequency bands at the same time.

During the implementation of the present invention, the inventor finds that the prior art at least has the following problems: in the prior art, it is very difficult to solve the problem that an operating bandwidth of a Doherty power amplifier is small, and the requirement that the Doherty power amplifier operate in multiple frequency bands at the same time cannot be met.

## SUMMARY

The objective of the present invention is to provide a Doherty power amplifier and a signal processing method according to the appended claims 1 and 7, respectively.

According to one aspect, an embodiment of the present invention further provides a base station device, which includes the foregoing Doherty power amplifier.

It can be seen from the technical solutions provided by the embodiments of the present invention that, a Doherty power amplifier of the embodiments of the present invention includes a wideband peak power amplifier and at least two narrowband carrier power amplifiers connected in parallel with the peak power amplifier, where an input end of the peak power amplifier receives a signal having at least two different narrowband frequency bands; an input end of each of the carrier power amplifiers receives a signal having one single narrowband frequency band of the at least two different narrowband frequency bands, an output end of each of the carrier power amplifier is connected in series with a first impedance transformation network, and output of the peak power amplifier and the carrier power amplifiers is combined and converted into load impedance by using the second impedance transformation network. According to the technical solutions, since the advantage of the Doherty power amplifier that narrowband operating efficiency is high is kept, the problem that an operating bandwidth of an existing Doherty power amplifier is small can be solved.

## BRIEF DESCRIPTION OF DRAWINGS

FIG. 1 is a schematic diagram of an existing Doherty power amplifier;
FIG. 2 is a schematic structural diagram of a Doherty power amplifier according to an embodiment of the present invention;
FIG. 3 is a diagram of a scenario of an embodiment of the present invention;
FIG. 4 is a diagram of a scenario of an embodiment of the present invention;
FIG. 5 is a schematic structural diagram of an inverse Doherty power amplifier; and
FIG. 6 is a flow chart of a signal processing method of a Doherty power amplifier according to an embodiment of the present invention.

## DESCRIPTION OF EMBODIMENTS

Embodiments of the present invention disclose a Doherty power amplifier and a signal processing method. A wideband peak power amplifier and at least two narrowband carrier power amplifiers form a Doherty power amplifier, so that the narrowband carrier power amplifiers separately operate in frequency sub-bands with small bandwidths, the advantage of the Doherty power amplifier that narrowband operating efficiency is high is kept, the problem that an operating bandwidth of an existing Doherty power amplifier is small is solved. In addition, in an application scenario where the Doherty power amplifier is applied in more than two frequency bands, the Doherty power amplifier provided by the present invention is capable of operating in at least two frequency sub-bands at the same time by increasing the number of narrowband carrier power amplifiers connected in parallel with the peak power amplifier.

To make the technical solutions of the embodiments of the present invention understood, description is provided in the following with reference to the embodiments and the accompanying drawings.

An embodiment of the present invention provides a Doherty power amplifier, and the technical solution includes:

the Doherty power amplifier, configured to perform power amplification on an input signal having N different narrowband frequency bands, where N is a positive integer greater than or equal to 2; and a wideband peak power amplifier and at least two narrowband carrier power amplifiers connected in parallel with the wideband peak power amplifier; where the wideband peak power amplifier is configured to perform power amplification on the input signal; the narrowband carrier power amplifiers are configured to separately perform power amplification on signals that have different single narrowband frequency bands and are in the input signal, and an output end of each of the at least two narrowband carrier power amplifiers is connected to one end of a first impedance transformation network; where after being connected to the other end of each of the N first impedance transformation networks, the wideband peak power amplifier is connected in series with a second impedance transformation network, and the second impedance transformation network is configured to convert output impedance into load impedance, so that active-load pulling is performed on the narrowband carrier power amplifier by using the wideband peak power amplifier.

Optionally, the first impedance transformation network includes a transmission line and a filter that are connected in series, the narrowband carrier power amplifier is connected to one end of the transmission line, and an electrical length of the transmission line is an odd multiple of $\lambda/4$.

In the embodiment of the present invention, an effect of setting the filter in the first impedance transformation network is: separating mutual impacts between the at least two narrowband carrier power amplifiers. For example, when two narrowband carrier power amplifiers 1 and 2 operate in two different frequency bands, and if no filter is used, the carrier power amplifier 1 functions as a load of the carrier power amplifier 2, and vice versa, therefore, output performance of the two narrowband carrier power amplifiers is affected, output power is lost, and reliability of a power tube is affected.

Optionally, when the filter is a narrowband low frequency filter, a bandpass or low-pass filter is adopted; or, when the filter is a narrowband high frequency filter, a bandpass or high-pass filter is adopted.

Optionally, the electrical length of the transmission line is set for the narrowband carrier power amplifiers of different input frequency bands according to a rule that an electrical length phase offset of the transmission line plus a phase offset of the filter is equal to an odd multiple of 90°.

A reason of setting the electrical length of the transmission line according to the foregoing rule is that: generally, it is required in design of a classic Doherty power amplifier that the electrical length of an operating frequency band of an impedance transformation network is 90°, and after a filter is introduced, the filter may very possibly cause a certain phase offset amount, so that the effect of the phase offset of the filter must be considered in the setting of the electrical length of the transmission line.

Optionally, the wideband peak power amplifier and the narrowband carrier power amplifier adopt power tubes of different power levels.

It should be noted that, in order to ensure a phase difference between signals of the peak power amplifier and the carrier power amplifier after output is combined, in the embodiment of the present invention, implementation may be performed by adding delay lines at input ends of the peak power amplifier and the carrier power amplifier, and the process is of the prior art, and therefore is not described herein in detail.

In order to describe the technical solution of the embodiment of the present invention, a specific scenario is introduced in the following for description.

It is assumed that a Doherty power amplifier provided by the present invention operates in two narrowband frequency bands f1 and f2.

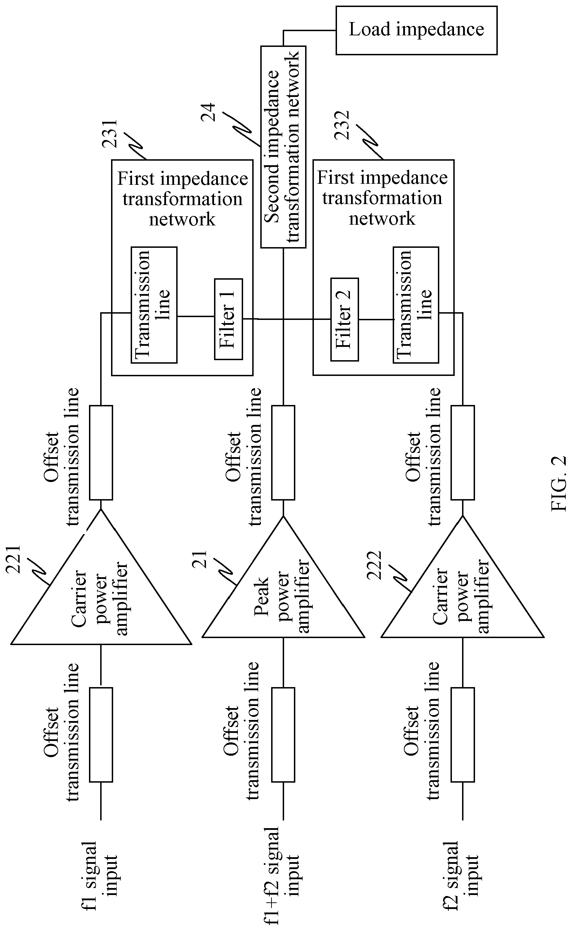

FIG. 2 includes a peak power amplifier 21 and two carrier power amplifiers 221 and 222 connected in parallel with a peak power amplifier, an input end of the peak power amplifier receives a signal having two different narrowband frequency bands f1 and f2; an input end of the carrier power amplifier 221 receives a signal having the single narrowband frequency band f1, an output end of the carrier power amplifier 221 is connected in series with a first impedance transformation network 231; an input end of the carrier power amplifier 222 receives a signal having the single narrowband frequency band f2, an output end of the carrier power amplifier 222 is connected in series with a first impedance transformation network 232; output of the peak power amplifier 21 and the carrier power amplifiers 221 and 222 is combined and then converted into load impedance $Z_0$ by using a second impedance transformation network 24, so that active-load pulling is performed on at least two carrier power amplifiers by using the peak power amplifier.

It should be noted that, in the embodiment of the present invention, the first impedance transformation network is an impedance transformation network connected in series with narrowband carrier power amplifiers, and in FIG. 2, the first impedance transformation network connected in series with the carrier power amplifier 221 is 231, and the first impedance transformation network connected in series with the carrier power amplifier 222 is 232.

In the embodiment of the present invention, the first impedance transformation network includes a transmission line whose electrical length is an odd multiple of $\lambda/4$ and a filter.

The second impedance transformation network is an impedance transformation network connected in series with combined output of the peak power amplifier and the carrier power amplifier, and in FIG. 2, the second impedance transformation network is 24.

To facilitate implementation of the technical solution of the embodiment of the present invention, it is required that in FIG. 2, the two carrier power amplifiers are narrowband amplifiers, the peak power amplifier is a wideband amplifier, and the frequency bands f1 and f2 are narrowband frequency bands.

In the first impedance transformation network, before the filter is used, when the carrier power amplifier 221 operates in the frequency band f1 and the carrier power amplifier 222 operates in the frequency band f2, the carrier power amplifier 221 functions as a load of the carrier power amplifier 222. Therefore, in the embodiment of the present invention, the effect of the filter is separating mutual impacts between the two carrier power amplifiers, so as to ensure output performance of the carrier power amplifiers, and improve reliability of a power tube.

In the embodiment of the present invention, when the filter is a narrowband low frequency filter, a bandpass or low-pass filter is adopted; when the filter is a narrowband high frequency filter, a bandpass or high-pass filter is adopted.

In addition, in the embodiment of the present invention, according to the rule that the electrical length phase offset of the transmission line plus a phase offset of the filter is equal to an odd multiple of 90°, the electrical length of the transmission line connected in series with the carrier power amplifier is set for the carrier power amplifier of different input frequency bands.

In the embodiment of the present invention, an operating bandwidth of the carrier power amplifier is consistent with that of an existing narrowband Doherty, and the peak power amplifier is a wideband power amplifier, and separately performs active-load pulling on the two narrowband carrier power amplifiers.

In the embodiment of the present invention, in order to ensure integrity of the technical solution, principles of the active-load pulling are described briefly.

A classic Doherty power amplifier is used as an example. Load impedance of a main power amplifier (a carrier power amplifier) and an auxiliary power amplifier (a peak power amplifier) of the classic Doherty power amplifier changes with input power . When the input power is low and the auxiliary power amplifier is not enabled, due to an effect of impedance transformation of a $\lambda/4$ transmission line, a load corresponding to the main power amplifier is K1=100Ω, and compared with an operating condition of the load being 50Ω, saturated output power of the main amplifier decreases by 3dB, and efficiency is high when output power is low; when the input power continues to increase, the auxiliary amplifier starts outputting power, the load of the main power amplifier changes from 100Ω to 50Ω, and when an output peak voltage remains in a saturated state, the output power of the main amplifier increases gradually, and meanwhile high efficiency is kept, and the load of the auxiliary power amplifier changes from infinity to 50Ω; when the input power continues to increase until the main and auxiliary power amplifiers each reach peak power, the loads corresponding to the main and auxiliary power amplifier are R1=R2=50Ω, and peak power and efficiency are the same as those of a common Class AB power amplifier; in this way, by using active-load pulling, the power back-off (Back off) efficiency is improved. It should be noted that the active-load pulling is a technology well known by a person skilled in the art, and is not described in detail herein again.

It can be seen from FIG. 2 that, the technical solution adopted in the embodiment of the present invention keeps the advantage of the Doherty power amplifier that narrowband operating efficiency is high, so that the problem that the operating bandwidth of an existing Doherty power amplifier is small is solved, and meanwhile, the Doherty power amplifier may operate in two or more frequency sub-bands at the same time in the technical solution provided by the embodiment of the present invention.

In the embodiment of the present invention, the second impedance transformation network (Zo→Zo/2 impedance transformation network) after the combined output ends of the peak power amplifier and the carrier power amplifiers may be implemented by adopting a multi-level wideband impedance transformation network or a wideband impedance transformation network of other types, which is not specifically limited in the embodiment of the present invention.

The Zo→Zo/2 impedance transformation network is obtained by using the following manner: the electrical length of the transmission line is 90°, and the square of impedance is equal to a product of impedance at two ends, so that Zo may be changed into a half of Zo by using a 90° transmission line of $Z_0/\sqrt{2}$ . The multi-level impedance transformation network adopts multiple 90° transmission lines, Zo is changed into an intermediate value first and is then gradually changed to Zo/2, and the operating bandwidth may be very large.

Further, the peak power amplifier and the carrier power amplifier adopt power tubes at different power levels to implement an asymmetric Dohery power amplifier, where asymmetry refers to that the carrier power amplifier and the peak power amplifier use power tubes of different power.

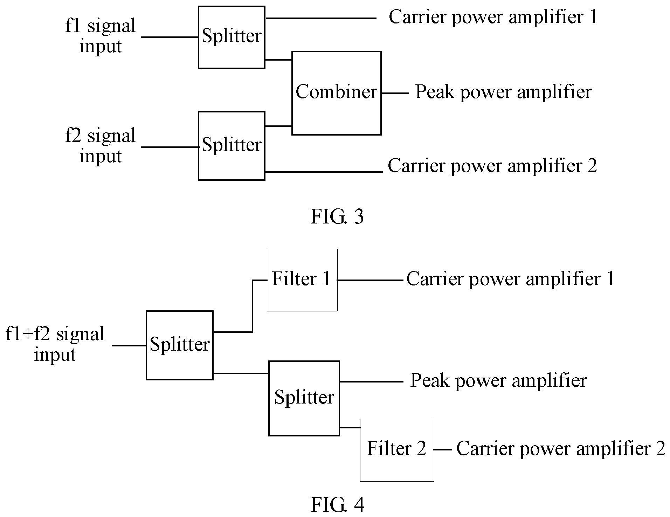

Further, as shown in FIG. 3 and FIG. 4, for input signals of a wideband peak power amplifier and at least two narrowband carrier power amplifiers, implementation may be specifically performed by using any one of the following two manners.

In FIG. 3, for a TX signal f1+f2, single signals f1 and f2 may be obtained by using splitting and filtering.

In FIG. 4, for two TX single signals f1 and f2, the single signals f1 and f2 may be obtained directly, where the wideband signal fl+f2 of the peak power amplifier may be obtained by using combining.

It should be noted that, the Dohery power amplifier provided by the embodiment of the present invention is applicable to an application scenario with at least two narrowband frequency bands, and when the Dohery power amplifier needs to operate in an application scenario with more than two frequency bands, under the premise that the peak power amplifier is capable of performing wideband operation, an implementation method is the same as that shown in FIG. 2, only the number of narrowband carrier power amplifiers needs to increased, and the advantage of the Doherty power amplifier that the narrowband operating efficiency is high is kept, so as to solve the problem that the operating bandwidth of an existing Doherty power amplifier is small.

It should be noted that, the method provided by the embodiment of the present invention for constructing a Doherty power amplifier is also applicable to an inverse Doherty power amplifier, and it is only required to change the peak power amplifier 21 into a carrier power amplifier, and change the carrier power amplifier 221 and the carrier power amplifier 222 into two peak power amplifiers. A specific technical solution may be achieved by using the following technical solution.

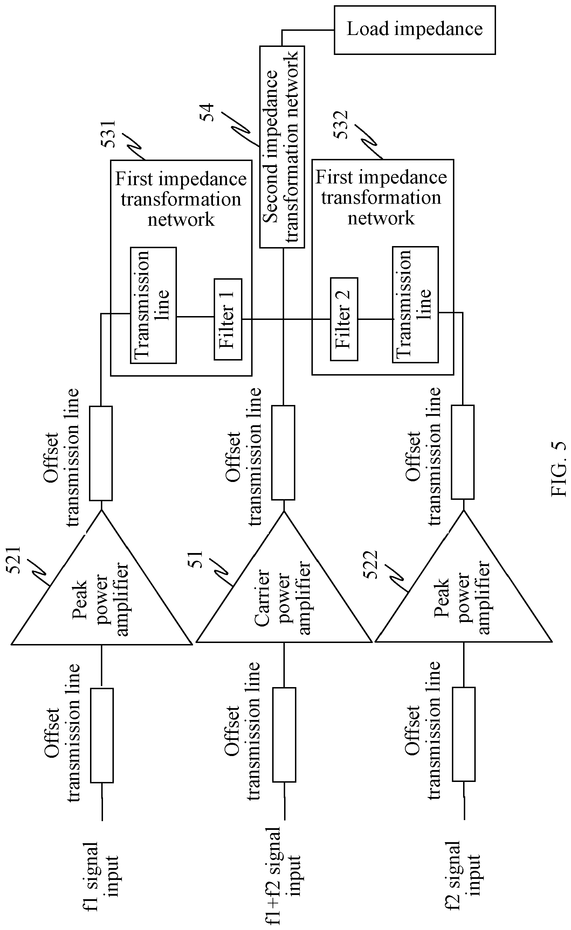

As shown in FIG. 5, an inverse Doherty power amplifier is configured to perform power amplification on an input signal having N different narrowband frequency bands, where N is a positive integer greater than or equal to 2, and the inverse Doherty power amplifier includes:

a wideband carrier power amplifier 51 and 2 narrowband peak power amplifiers 521 and 522 connected in parallel with the wideband carrier power amplifier 51, where the wideband carrier power amplifier 51 is configured to perform power amplification on an input signal having frequency bands fl+f2; the narrowband peak power amplifiers are configured to separately perform power amplification on signals that have different single narrowband frequency bands f1 and f2 and are in the input signal, and an output end of each of the 2 narrowband peak power amplifiers is connected to one end of a first impedance transformation network; for example, the peak power amplifier 521 is connected to a first impedance transformation network 531, and the peak power amplifier 522 is connected to a first impedance transformation network 532; where

after being connected to the other end of each of the 2 first impedance transformation networks, the wideband carrier power amplifier 51 is connected in series with a second impedance transformation network 54, and the second impedance transformation network is configured to convert output impedance into load impedance, so that active-load pulling is performed on the carrier power amplifier by using the peak power amplifier.

The inverse Doherty power amplifier in FIG. 5 is implemented by using a constructing method of the Doherty power amplifier shown in FIG. 2, and includes corresponding technical features, and for specific involved technical solutions, reference may be made to related descriptions in the embodiment of FIG. 2, which are not repeated herein.

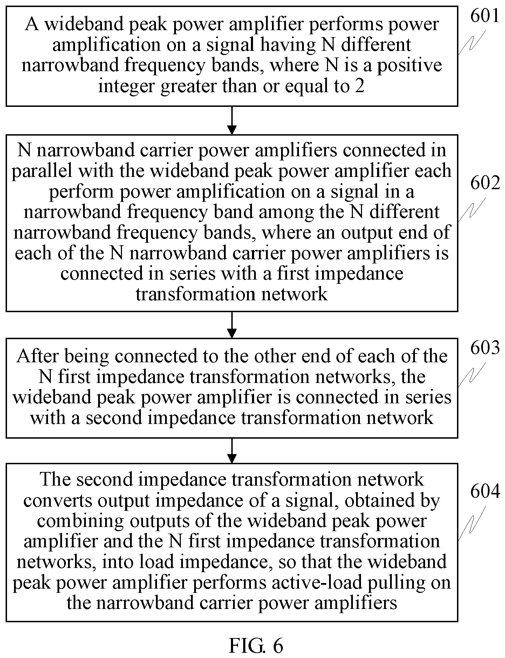

As shown in FIG. 6, based on the embodiment shown in FIG. 2, an embodiment of the present invention provides a signal processing method of a Doherty power amplifier, and the technical solution includes the following steps.

601: A wideband peak power amplifier performs power amplification on a signal having N different narrowband frequency bands, where N is a positive integer greater than or equal to 2.

602: N narrowband carrier power amplifiers connected in parallel with the wideband peak power amplifier separately perform power amplification on a signal in a narrowband frequency band among the N different narrowband frequency bands, where an output end of each of the N narrowband carrier power amplifiers is connected in series with a first impedance transformation network.

603: After being connected to the other end of each of the N first impedance transformation networks, the wideband peak power amplifier is connected in series with a second impedance transformation network.

604: The second impedance transformation network converts output impedance of a signal, obtained by combining output of the wideband peak power amplifier and the N first impedance transformation networks, into load impedance, so that the wideband peak power amplifier performs active-load pulling on the narrowband carrier power amplifiers.

Further, the method further includes that:
the first impedance transformation network includes a transmission line and a filter that are connected in series, an output end of the narrowband carrier power amplifier is connected to one end of the transmission line, and an electrical length of the transmission line is an odd multiple of $\lambda/4$.

Further, when the filter is a narrowband low frequency filter, a bandpass or low-pass filter is adopted; or, when the filter is a narrowband high frequency filter, a bandpass or high-pass filter is adopted.

Further, the method further includes:
according to a rule that the electrical length phase offset of the transmission line plus a phase offset of the filter is equal to an odd multiple of 90°, setting the electrical length of the transmission line connected in series with the narrowband carrier power amplifier for the narrowband carrier power amplifier of different input frequency bands.

Further, the peak power amplifier and the carrier power amplifiers adopt power tubes at different power levels to implement an asymmetric Dohery power amplifier.

It should be noted that, the method embodiment shown in FIG. 6 is obtained according to the embodiment shown in FIG. 2, and includes technical features same as those in the embodiment of FIG. 2, so that the involved technical solutions are not described in detail, and for details, reference may be made to the embodiment shown in FIG. 2.

Based on the embodiment of a Dohery power amplifier shown in FIG. 2, the present invention further provides a base station device including the Dohery power amplifier.

In summary, the embodiments of the present invention provide a Doherty power amplifier and a signal processing method, where a wideband amplifier and multiple narrowband amplifiers are connected in parallel, so that the Doherty power amplifier provided by the present invention can operate in at least two different frequency sub-bands at the same time, and meanwhile, the advantage of the Doherty power amplifier that narrowband operating efficiency is high is kept, so as to solve the problem that an operating bandwidth of an existing Doherty power amplifier is small, and improve the operating efficiency of the Doherty power amplifier.

The Doherty power amplifier in the embodiment of the present invention is applicable to the field of wireless communications, and is also applicable to other fields of communications such as radar, microwave, and satellite communications.

A person of ordinary skill in the art may understand that all or a part of the processes of the methods in the foregoing embodiments may be implemented by a computer program instructing relevant hardware. The program may be stored in a computer readable storage medium. When the program runs, the processes of the methods in the embodiments are performed. The storage medium may be a magnetic disk, an optical disc, a read-only memory (Read-Only Memory, ROM), or a random access memory (Random Access Memory, RAM).

**Claims**

1. A Doherty power amplifier, wherein the Doherty power amplifier is configured to perform power amplification on an input signal having N different narrowband frequency bands, and N is a positive integer greater than or equal to 2, the Doherty power amplifier comprising:

   a wideband peak power amplifier (21) and N narrowband carrier power amplifiers (221, 222) connected in parallel with the wideband peak power amplifier; wherein the wideband peak power amplifier is configured to perform power amplification on the input signal; the narrowband carrier power amplifiers are configured to separately perform power amplification on signals that have different single narrowband frequency bands and are in the input signal, and an output end of each of the N narrowband carrier power amplifiers is connected to one end of one of N respective first impedance transformation networks (231, 232); wherein
   the output of the wideband peak power amplifier is connected to the other end of each of the N first impedance transformation networks and is connected in series with a second impedance transformation network (24), and the second impedance transformation network is configured to convert an output impedance into a impedance, so that the peak power amplifier performs active-load pulling on the narrowband carrier power amplifiers.

2. The power amplifier according to claim 1, wherein the first impedance transformation network comprises a transmission line and a filter that are connected in series, the narrowband carrier power amplifier is connected to one end of the transmission line, and an electrical length of the transmission line is an odd multiple of $\lambda/4$.

3. The power amplifier according to claim 2, wherein the filter is a narrowband low frequency filter implemented as a bandpass or low-pass filter, or a narrowband high frequency filter implemented as a bandpass or high-pass filter.

4. The power amplifier according to claim 2 or 3, wherein the electrical length of the transmission line is set for the narrowband carrier power amplifiers of different input frequency bands according to a rule that an electrical length phase offset of the transmission line plus a phase offset of the filter is equal to an odd multiple of 90°.

5. The power amplifier according to any one of claims 1 to 4, wherein the wideband peak power amplifier and the narrowband carrier power amplifier comprise power tubes of different power levels.

6. A base station device, comprising the Doherty power amplifier according to any one of claims 1 to 5.

7. A signal processing method of a Doherty power amplifier, comprising:

   performing, by a wideband peak power amplifier (21), power amplification on a signal having N different narrowband frequency bands, wherein N is a positive integer greater than or equal to 2; separately performing, by N narrowband carrier power amplifiers (221, 222) connected in parallel with the wideband peak power amplifier, power amplification on a signal in a narrowband frequency band among the N different narrowband frequency bands, wherein an output end of each of the N narrowband carrier power amplifiers is connected in series with one of N respective first impedance transformation networks (231, 232); the output of the wideband peak power amplifier being connected to the other end of each of the N first impedance transformation networks and in series to a second impedance transformation network (24); and
   converting, by the second impedance transformation network, an output impedance, obtained by combining the output of the wideband peak power amplifier and the N first impedance transformation networks, into a load impedance, so that the wideband peak power amplifier performs active-load pulling on the narrowband carrier power amplifiers.

8. The method according to claim 7, further comprising that:
the first impedance transformation network comprises a transmission line and a filter that are connected in series, an output end of the narrowband carrier power amplifier is connected to one end of the transmission line, and an electrical length of the transmission line is an odd multiple of $\lambda/4$.

9. The method according to claim 8, wherein the filter is a narrowband low frequency filter implemented as a bandpass or low-pass filter, or a narrowband high frequency filter implemented as a bandpass or high-pass filter.

10. The method according to claim 8 or 9, further comprising:
according to a rule that an electrical length phase offset of the transmission line plus a phase offset of the filter is equal to an odd multiple of 90°, setting the electrical length of the transmission line connected in series with each narrowband carrier power amplifier.

11. The method according to any one of claims 7 to 10, wherein the wideband peak power amplifier and the narrowband carrier power amplifier comprise power tubes of different power levels.

**Patentansprüche**

1. Doherty-Leistungsverstärker, wobei der Doherty-Leistungsverstärker dafür ausgelegt ist, eine Leistungsverstärkung an einem Eingangssignal durchzuführen, das N unterschiedliche Frequenzbänder aufweist, und N eine positive ganze Zahl größer als oder gleich 2 ist, der Doherty-Leistungsverstärker aufweisend:

einen Breitbandspitzenleistungsverstärker (21) und N Schmalbandträgerleistungsverstärker (221, 222), die mit dem Breitbandspitzenleistungsverstärker parallelgeschaltet sind; wobei der Breitbandspitzenleistungsverstärker dafür ausgelegt ist, eine Leistungsverstärkung an dem Eingangssignal durchzuführen; die Schmalbandträgerleistungsverstärker dafür ausgelegt sind, eine Leistungsverstärkung an Signalen, die unterschiedliche einzelne Schmalbandfrequenzbänder aufweisen und in dem Eingangssignal vorliegen, separat durchzuführen, und ein Ausgangsende von jedem der N Schmalbandträgerleistungsverstärker mit einem Ende von einem von N jeweiligen ersten Impedanztransformationsnetzwerken (231, 232) verbunden ist; wobei
der Ausgang des Breitbandspitzenleistungsverstärkers mit dem anderen Ende von jedem der N ersten Impedanztransformationsnetzwerke verbunden ist und mit einem zweiten Impedanztransformationsnetzwerk (24) in Reihe geschaltet ist, und das zweite Impedanztransformationsnetzwerk dafür ausgelegt ist, eine Ausgangsimpedanz derart in eine Impedanz umzuwandeln, dass der Spitzenleistungsverstärker einen aktiven Load-Pull an den Schmalbandträgerleistungsverstärkern durchführt.

2. Leistungsverstärker nach Anspruch 1, wobei das erste Impedanztransformationsnetzwerk eine Übertragungsleitung und einen Filter, die in Reihe geschaltet sind, aufweist, der erste Schmalbandträgerleistungsverstärker mit einem Ende der Übertragungsleitung verbunden ist und eine elektrische Länge der Übertragungsleitung ein ungeradzahliges Vielfaches von $\lambda/4$ ist.

3. Leistungsverstärker nach Anspruch 2, wobei der Filter ein Schmalbandniederfrequenzfilter, der als ein Bandpass- oder Tiefpassfilter implementiert ist, oder ein Schmalbandhochfrequenzfilter, der als ein Bandpass- oder Hochpassfilter implementiert ist, ist.

4. Leistungsverstärker nach Anspruch 2 oder 3, wobei die elektrische Länge der Übertragungsleitung für die Schmalbandträgerleistungsverstärker unterschiedlicher Eingangsfrequenzbänder entsprechend einer Regel eingestellt ist, dass ein Phasenversatz der elektrischen Länge der Übertragungsleitung und ein Phasenversatz des Filters gleich einem ungeradzahligen Vielfachen von 90° ist.

5. Leistungsverstärker nach einem der Ansprüche 1 bis 4, wobei der Breitbandspitzenleistungsverstärker und der Schmalbandträgerleistungsverstärker Leistungsröhren unterschiedlicher Leistungspegel aufweisen.

6. Basisstationsvorrichtung, die den Doherty-Leistungsverstärker nach einem der Ansprüche 1 bis 5 aufweist.

7. Signalverarbeitungsverfahren eines Doherty-Leistungsverstärkers, umfassend:

Durchführen, durch einen Breitbandspitzenleistungsverstärker (21), einer Leistungsverstärkung an einem Signal, das N unterschiedliche Schmalbandfrequenzbänder aufweist, wobei N eine positive ganze Zahl größer als oder 2 ist;

separates Durchführen, durch N Schmalbandträgerleistungsverstärker (221, 222), die mit dem Breitbandspitzenleistungsverstärker parallelgeschaltet sind, einer Leistungsverstärkung an einem Signal in einem Schmalbandfrequenzband unter den N unterschiedlichen Schmalbandfrequenzbändern, wobei ein Ausgangsende von jedem der N Schmalbandträgerleistungsverstärker mit einem von N jeweiligen ersten Impedanztransformationsnetzwerken (231, 232) in Reihe geschaltet ist;

wobei der Ausgang des Breitbandspitzenleistungsverstärkers mit dem anderen Ende von jedem der N ersten Impedanztransformationsnetzwerke verbunden ist und mit einem zweiten Impedanztransformationsnetzwerk (24) in Reihe geschaltet ist; und

Umwandeln, durch das zweite Impedanztransformationsnetzwerk, einer Ausgangsimpedanz, die durch Kombinieren der Ausgabe von dem Breitbandspitzenleistungsverstärker und den N ersten Impedanztransformationsnetzwerken erhalten wird, derart in eine Lastimpedanz, dass der Breitbandspitzenleistungsverstärker einen aktiven Load-Pull an den Schmalbandträgerleistungsverstärkern durchführt.

8. Verfahren nach Anspruch 7, ferner umfassend, dass:

das erste Impedanztransformationsnetzwerk eine Übertragungsleitung und einen Filter, die in Reihe geschaltet sind, aufweist, ein Ausgangsende des Schmalbandträgerleistungsverstärkers mit einem Ende der Übertragungsleitung verbunden ist und eine elektrische Länge der Übertragungsleitung ein ungeradzahliges Vielfaches von λ/4 ist.

9. Verfahren nach Anspruch 8, wobei der Filter ein Schmalbandniederfrequenzfilter, der als ein Bandpass- oder Tiefpassfilter implementiert ist, oder ein Schmalbandhochfrequenzfilter, der als ein Bandpass- oder Hochpassfilter implementiert ist, ist.

10. Verfahren nach Anspruch 8 oder 9, ferner umfassend:

entsprechend einer Regel, dass ein Phasenversatz der elektrischen Länge der Übertragungsleitung und ein Phasenversatz des Filters gleich einem ungeradzahligen Vielfachen von 90° ist, Einstellen der elektrischen Länge der Übertragungsleitung, die mit jedem Schmalbandträgerleistungsverstärker in Reihe geschaltet ist.

11. Verfahren nach einem der Ansprüche 7 bis 10, wobei der Breitbandspitzenleistungsverstärker und der Schmalbandträgerleistungsverstärker Leistungsröhren unterschiedlicher Leistungspegel aufweisen.

**Revendications**

1. Amplificateur de puissance de Doherty, dans lequel l'amplificateur de puissance de Doherty est configuré pour effectuer une amplification de puissance sur un signal d'entrée présentant N bandes de fréquence à bande étroite différentes, et N est un nombre entier positif supérieur ou égal à 2, l'amplificateur de puissance de Doherty comprenant :

un amplificateur (21) de puissance de crête à bande large et N amplificateurs de puissance à courant porteur à bande étroite (221, 222) connectés en parallèle avec l'amplificateur de puissance de crête à bande large ; dans lequel l'amplificateur de puissance de crête à bande large est configuré pour effectuer une amplification de puissance sur le signal d'entrée ; les amplificateurs de puissance à courant porteur à bande étroite sont configurés pour effectuer séparément une amplification de puissance sur des signaux qui présentent des bandes de fréquence à une seule bande étroite différentes et qui se trouvent dans le signal d'entrée, et une extrémité de sortie de chacun des N amplificateurs de puissance à courant porteur à bande étroite est connectée à une extrémité d'un de N premiers réseaux de transformation d'impédance (231, 232) respectifs ; dans lequel la sortie de l'amplificateur de puissance de crête à bande large est connectée à l'autre extrémité de chacun des N premiers réseaux de transformation d'impédance et est connectée en série avec un deuxième réseau de transformation d'impédance (24), et le deuxième réseau de transformation d'impédance est configuré pour convertir une impédance de sortie en une impédance de telle sorte que l'amplificateur de puissance de crête effectue une traction de charge active sur les amplificateurs de puissance à courant porteur à bande étroite.

2. Amplificateur de puissance selon la revendication 1, dans lequel le premier réseau de transformation d'impédance comprend une ligne de transmission et un filtre qui sont connectés en série, l'amplificateur de puissance à courant porteur à bande étroite est connecté à une extrémité de la ligne de transmission, et une longueur électrique de la ligne de transmission est un multiple impair de λ/4.

3. Amplificateur de puissance selon la revendication 2, dans lequel le filtre est un filtre basse fréquence à bande étroite mis en oeuvre comme filtre passe-bande ou passe-bas ou un filtre haute fréquence à bande étroite mis en oeuvre comme filtre passe-bande ou passe-haut.

4. Amplificateur de puissance selon la revendication 2 ou 3, dans lequel la longueur électrique de la ligne de transmission est réglée pour les amplificateurs de puissance à courant porteur à bande étroite de différentes bandes de fréquence d'entrée selon une règle exigeant qu'un décalage de phase de longueur électrique de la ligne de transmission plus un décalage de phase du filtre soit égal à un multiple impair de 90°.

5. Amplificateur de puissance selon l'une quelconque des revendications 1 à 4, dans lequel l'amplificateur de puissance de crête à bande large et l'amplificateur de puissance à courant porteur à bande étroite comprennent des tubes de puissance de différents niveaux de puissance.

6. Dispositif de station de base, comprenant l'amplificateur de puissance de Doherty selon l'une quelconque des revendications 1 à 5.

7. Procédé de traitement de signal d'un amplificateur de puissance de Doherty, comprenant les étapes consistant à :

effectuer, par un amplificateur (21) de puissance de crête à bande large, une amplification de puissance sur un signal présentant N bandes de fréquence à bande étroite différentes, N étant un nombre entier positif supérieur ou égal à 2 ; effectuer séparément, par N amplificateurs de puissance de crête à bande étroite (221, 222) connectés en parallèle avec l'amplificateur de puissance de crête à bande large, une amplification de puissance sur un signal dans une bande de fréquence à bande étroite parmi les N bandes de fréquence à bande étroite différentes, dans lequel une extrémité de sortie de chacun des N amplificateurs de puissance à courant porteur à bande étroite est connectée en série avec l'un de N premiers réseaux de transformation d'impédance (231, 232) respectifs ; la sortie de l'amplificateur de puissance de crête à bande large étant connectée à l'autre extrémité de chacun des N premiers réseaux de transformation d'impédance et en série avec un deuxième réseau de transformation d'impédance (24) ; et convertir, par le deuxième réseau de transformation d'impédance, une impédance de sortie, obtenue en combinant la sortie de l'amplificateur de puissance de crête à bande large et les N premiers réseaux de transformation d'impédance, en une impédance de charge, de sorte que l'amplificateur de puissance de crête à bande large effectue une traction de charge active sur les amplificateurs de puissance à courant porteur à bande étroite.

8. Procédé selon la revendication 7, comprenant en outre que :
le premier réseau de transformation d'impédance comprend une ligne de transmission et un filtre qui sont connectés en série, une extrémité de sortie de l'amplificateur de puissance à courant porteur à bande étroite est connectée à une extrémité de la ligne de transmission, et une longueur électrique de la ligne de transmission est un multiple impair de $\lambda/4$.

9. Procédé selon la revendication 8, dans lequel le filtre est un filtre basse fréquence à bande étroite mis en oeuvre comme filtre passe-bande ou passe-bas ou un filtre haute fréquence à bande étroite mis en oeuvre comme un filtre passe-bande ou passe-haut.

10. Procédé selon la revendication 8 ou 9, comprenant en outre :
selon une règle exigeant qu'un décalage de phase de longueur électrique de la ligne de transmission plus un décalage de phase du filtre soit égal à un multiple impair de 90°, régler la longueur électrique de la ligne de transmission connectée en série avec chaque amplificateur de puissance à courant porteur à bande étroite.

11. Procédé selon l'une quelconque des revendications précédentes 7 à 10, dans lequel l'amplificateur de puissance de crête à bande large et l'amplificateur de puissance à courant porteur à bande étroite comprennent des tubes de puissance de différents niveaux de puissance.

Input —

Carrier
power
amplifier

λ/4
transmission
line

Peak
power
amplifier

Offset
transmission line

Offset
transmission line

λ/4 transmission line
Zo

λ/4 transmission line
$Z_0/\sqrt{2}$

Load
Zo

FIG. 1

FIG. 2

f1 signal
input —— | Splitter | —————— Carrier power amplifier 1

| Combiner | —— Peak power amplifier

f2 signal
input —— | Splitter | —————— Carrier power amplifier 2

FIG. 3

| Filter 1 | —————— Carrier power amplifier 1

f1+f2 signal
input —— | Splitter |

| Splitter | —————— Peak power amplifier

| Filter 2 | —— Carrier power amplifier 2

FIG. 4

FIG. 5

A wideband peak power amplifier performs power amplification on a signal having N different narrowband frequency bands, where N is a positive integer greater than or equal to 2 — 601

N narrowband carrier power amplifiers connected in parallel with the wideband peak power amplifier each perform power amplification on a signal in a narrowband frequency band among the N different narrowband frequency bands, where an output end of each of the N narrowband carrier power amplifiers is connected in series with a first impedance transformation network — 602

After being connected to the other end of each of the N first impedance transformation networks, the wideband peak power amplifier is connected in series with a second impedance transformation network — 603

The second impedance transformation network converts output impedance of a signal, obtained by combining outputs of the wideband peak power amplifier and the N first impedance transformation networks, into load impedance, so that the wideband peak power amplifier performs active-load pulling on the narrowband carrier power amplifiers — 604

FIG. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2159912 A